(19)

Europäisches
Patentamt
European
Patent Office
Office européen
des brevets

(11) **EP 4 603 850 A1**

(12) **EUROPEAN PATENT APPLICATION**
published in accordance with Art. 153(4) EPC

(43) Date of publication:
**20.08.2025 Bulletin 2025/34**

(21) Application number: **23917060.8**

(22) Date of filing: **19.09.2023**

(51) International Patent Classification (IPC):
***G01R 31/367*** (2019.01)

(86) International application number:
**PCT/CN2023/119842**

(87) International publication number:
**WO 2024/152592 (25.07.2024 Gazette 2024/30)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.01.2023 CN 202310077015**

(71) Applicant: **Chongqing Changan Automobile Co.,
Ltd.
Chongqing 400023 (CN)**

(72) Inventors:
• **ZHENG, Changwen
Chongqing 400023 (CN)**
• **ZHENG, Ying
Chongqing 400023 (CN)**
• **ZHU, Qian
Chongqing 400023 (CN)**
• **YANG, Xu
Chongqing 400023 (CN)**
• **YU, Cheng
Chongqing 400023 (CN)**

(74) Representative: **Schulz Junghans
Patentanwälte PartGmbB
Großbeerenstraße 71
10963 Berlin (DE)**

(54) **METHOD AND APPARATUS FOR ESTIMATING SOC OF BATTERY, AND DEVICE, BATTERY MODULE AND STORAGE MEDIUM**

(57) Disclosed is a method and apparatus for estimating the SOC of a battery, a device, a battery module, and a storage medium. The method includes: fitting a relationship between open-circuit voltage (OCV) and the state of charge (SOC) based on the OCV corresponding to an SOC range of 0 to 100% to obtain an OCV-SOC function; creating a Thevenin model of a tested battery pack based on equivalent circuit parameters and the OCV-SOC function; inputting real-time parameters acquired from a to-be-tested battery pack into the Thevenin model for detection according to a preset VFF-RLS algorithm with a time-varying forgetting factor; jointly determining a maximum SOC and a minimum SOC based on a preset noise adaptive extended Kalman filter (AEKF) algorithm and the Thevenin model; and determining an overall SOC of the to-be-tested battery pack according to the maximum SOC and the minimum SOC. In this way, the accuracy for estimating the overall SOC can be improved.

Fit a relationship between an open-circuit voltage (OCV) and a state of charge (SOC) based on the OCV corresponding to an SOC range of 0 to 100% for a tested battery pack to obtain an OCV-SOC function — 110

Create a Thevenin model of the tested battery pack based on equivalent circuit parameters of a battery cell in the tested battery pack and the OCV-SOC function — 120

Input real-time parameters acquired from a to-be-tested battery pack into the Thevenin model for detection according to a preset VFF-RLS algorithm with a time-varying forgetting factor to obtain an output result, the output result including a terminal voltage and a terminal voltage residual — 130

ointly determine a maximum SOC corresponding to a maximum cell voltage in the real-time parameters and a minimum SOC corresponding to a minimum cell voltage in the real-time parameters based on a preset noise adaptive extended Kalman filter (AEKF) algorithm and the Thevenin model and according to the real-time parameters of the to-be-tested battery pack and the output result — 140

Determine an overall SOC of the to-be-tested battery pack according to the maximum SOC and the minimum SOC — 150

Fig. 1

EP 4 603 850 A1

**Description**

**Field of the Invention**

The present application relates to the technical field of battery management, and in particular, to a method and apparatus for estimating a state of charge (SOC) of a battery, a device, a battery module, and a storage medium.

**Background of the Invention**

At present, lithium-ion batteries are widely used in new energy vehicles due to their advantages such as high cell voltage, high energy density, long cycle life, and low self-discharge rate. As a crucial energy storage unit of the new energy vehicle, a state of charge (SOC) of the lithium-ion battery has significant importance for battery state monitoring and vehicle operation. Therefore, the SOC estimation is one of core functions of a battery management system.

Since the SOC is an internal state variable of the battery rather than a directly measurable value, the battery management system (BMS) can estimate the SOC based on acquired current, voltage, and temperature signals in a given way. Conventional SOC estimation methods include an ampere-hour integral method and an open-circuit voltage method. The ampere-hour integral method cannot eliminate accumulated errors in SOC estimation and is significantly affected by an initial value of the SOC and the accuracy of a current sensor. The open-circuit voltage method has poor real-time performance, and usually requires the battery to remain at rest for an extended period before a terminal voltage can be measured, in order to obtain accurate open-circuit voltage (OCV), which is then used to estimate the SOC through a lookup table. At present, data-based and model-based methods gradually become two mainstream SOC estimation methods capable of solving the problems of the aforementioned conventional SOC estimation methods.

The data-based method includes a neural network, a support vector machine, deep learning, etc., and usually requires vast sample data for training, which makes it difficult to actually implement in the BMS. The model-based method includes a mechanism-based model, an equivalent circuit-based model, etc., which estimates the SOC by constructing precise battery models. The accuracy of the battery models is influenced by model parameters. The battery model parameters identified based on offline test data generally provide high accuracy for fresh batteries. However, the offline test generally requires a relatively long test period and involves relatively limited test samples and granularity. Moreover, since the battery parameters vary with factors such as battery aging, temperature difference in a battery pack, and differences in battery processes/materials, the battery model that is constructed by using the offline identified parameters has poor adaptability under conditions such as full lifecycle operation, a temperature-varying environment, and large-scale battery configurations, which may reduce the SOC estimation accuracy. Furthermore, initial parameters of a conventional extended Kalman filter algorithm are usually fixed values, but actual battery operation conditions may fail to satisfy an assumption of noise in the algorithm, which affects the performance of the algorithm.

**Summary of the Invention**

In view of this, an objective of an embodiment of the present application is to provide a method and apparatus for estimating a state of charge (SOC) of a battery, a device, a battery module, and a storage medium, to improve the accuracy for estimating the SOC of the battery.

To achieve the above objective, the present application adopts the following technical solutions:

In a first aspect, an embodiment of the present application provides a method for estimating a state of charge (SOC) of a battery, which includes:

fitting a relationship between an open-circuit voltage (OCV) and the SOC based on the OCV corresponding to an SOC range of 0 to 100% for a tested battery pack to obtain an OCV-SOC function;

creating a Thevenin model of the tested battery pack based on equivalent circuit parameters of a battery cell in the tested battery pack and the OCV-SOC function;

inputting real-time parameters acquired from a to-be-tested battery pack into the Thevenin model for detection according to a preset VFF-RLS algorithm with a time-varying forgetting factor to obtain an output result, the output result including a terminal voltage and a terminal voltage residual;

jointly determining a maximum SOC corresponding to a maximum cell voltage in the real-time parameters and a minimum SOC corresponding to a minimum cell voltage in the real-time parameters based on a preset noise adaptive extended Kalman filter (AEKF) algorithm and the Thevenin model and according to the real-time parameters of the to-be-tested battery pack and the output result; and

determining an overall SOC of the to-be-tested battery pack according to the maximum SOC and the minimum SOC.

According to the first aspect, in some optional embodiments, the OCV-SOC function is expressed as:

$$U_{ocv}(SOC)=aSOC+bSOC^2+cSOC^3+d/SOC+e\ln(SOC)+f\ln(1-SOC)$$

where $U_{ocv}$ represents the open-circuit voltage of the battery, $SOC$ represents the state of charge of the battery, and a, b, c, d, e, and f each represents a fitting coefficient.

According to the first aspect, in some optional embodiments, the Thevenin model is expressed as:

$$\begin{cases} \dot{U}_p = \dfrac{I}{C_p} - \dfrac{U_p}{R_p C_p} \\ U_t = U_{ocv} - IR_0 - U_p \end{cases}$$

where $U_p$ represents a polarization voltage of the battery, $I$ represents current, $R_0$ represents ohm internal resistance, $R_p$ represents polarization internal resistance, $C_p$ represents a polarization capacitance, $U_t$ represents the terminal voltage of the battery, and $U_{ocv}$ represents the open-circuit voltage of the battery.

According to the first aspect, in some optional embodiments, the inputting real-time parameters acquired from a to-be-tested battery pack into the Thevenin model for detection according to a preset VFF-RLS algorithm with a time-varying forgetting factor to obtain an output result includes:

performing Laplace transform on the Thevenin model to obtain a system transfer function as follows:

$$G(s) = \frac{U_t(s)-U_{ocv}(s)}{I(s)} = -\frac{R_0+R_p+R_0 R_p C_p s}{1+R_p C_p s}$$

where $U_t(s)$ represents the terminal voltage in the transfer function, and s represents a complex variable in the Laplace transform;

performing bilinear transform on the transfer function $G(s)$, and mapping the transfer function to a z-plane to obtain:

$$G(z^{-1}) = -\frac{\dfrac{R_0+R_p+2R_0 R_p C_p}{1+2R_p C_p} + \dfrac{R_0+R_p-2R_0 R_p C_p}{1+2R_p C_p} z^{-1}}{1+\dfrac{1-2R_p C_p}{1+2R_p C_p} z^{-1}}$$

transforming a mathematical expression of the Thevenin model to obtain:

$$E_k = U_{ocv,k} - U_{t,k} = a_1 E_{k-1} - R_0 I_k - [(1-a_1)R_p I_{k-1} - a_1 R_0 I_{k-1}] = a_1 E_{k-1} + a_2 I_k + a_3 I_{k-1}$$

where $E_k$ represents an ohm voltage drop and a polarization voltage drop of the battery at time k, $U_{ocv,k}$ represents the open-circuit voltage at time k, $U_{t,k}$ represents a real-time voltage acquired from the to-be-tested battery pack at time k, and $I_k$ represents real-time current acquired from the to-be-tested battery pack at time k;

expressing, by using the parameters of the Thevenin model, parameters $a_1$, $a_2$, and $a_3$ based on the transfer function G(s) as:

$$\begin{cases} a_1 = \dfrac{1 - 2R_pC_p}{1 + 2R_pC_p} \\[2em] a_2 = -\dfrac{R_0 + R_p + 2R_pC_p}{1 + 2R_pC_p} \\[2em] a_3 = -\dfrac{R_0 + R_p - 2R_pC_p}{1 + 2R_pC_p} \end{cases}$$

establishing a to-be-identified system $y_k = \varphi_k \theta_k^T$ , where $y_k$ represents an output of the to-be-identified system, $\varphi_k = [E_{k-1}, I_k, I_{k-1}]$ represents an input vector of the to-be-identified system, and $\theta_k = [a_{1,k}, a_{2,k}, a_{3,k}]$ represents a parameter vector;

introducing the time-varying forgetting factor $\lambda_k$ into an observation variance matrix for correction, $\lambda_k$ being expressed as:

$$\lambda_k = \lambda_{\min} + (1 - \lambda_{\min})^{\beta_k}$$

where $\beta_k = 2^{\rho e_k^2}$ , $\lambda_{\min}$ represents a lower limit value of the time-varying forgetting factor $\lambda_k$, $\rho$ is a parameter for adjusting the time-varying forgetting factor $\lambda_k$, and $e_k$ represents the terminal voltage residual identified by using the VFF-RLS algorithm at time k;

identifying the Thevenin model according to the VFF-RLS algorithm and the real-time parameters to obtain an identification result, the identification result including the ohm internal resistance $R_0$, the polarization internal resistance $R_p$, and a time constant $\tau = R_pC_p$; and

substituting the identification result into the Thevenin model to obtain the output result including the terminal voltage and the terminal voltage residual.

According to the first aspect, in some optional embodiments, in the time-varying forgetting factor, $\lambda_{\min} = 0.95$ $\lambda_k \in$ [0.95,1], and $\rho = 0.5$.
According to the first aspect, in some optional embodiments, the jointly determining a maximum SOC corresponding to a maximum cell voltage in the real-time parameters and a minimum SOC corresponding to a minimum cell voltage in the real-time parameters based on a preset noise adaptive extended Kalman filter (AEKF) algorithm and the Thevenin model and according to the real-time parameters of the to-be-tested battery pack and the output result includes:

establishing a battery SOC calculation formula based on an ampere-hour integral, the formula being expressed as:

$$SOC_{k+1} = SOC_0 + \int_0^k \frac{\eta I \Delta t}{Q_n}$$

where $SOC_{k+1}$ represents the SOC at time k+1, $SOC_0$ represents an initial value of the SOC of the battery, $\eta$ represents a Coulomb coefficient, $I$ represents acquired real-time current, $\Delta t$ represents a sampling period, and $Q_n$ represents a rated capacity of the battery;
establishing a system discrete state-space equation based on the output result of the Thevenin model and the SOC calculated by using the ampere-hour integral, a system state variable being $x = (SOC, U_p)$, an input being $u = I$, an output being $y = U_t$, and the space equation being expressed as:

$$\begin{cases} \begin{bmatrix} SOC_{k+1} \\ U_{p,k+1} \end{bmatrix} = A \begin{bmatrix} SOC_k \\ U_{p,k} \end{bmatrix} + BI_k + \omega_k \\ U_{t,k+1} = U_{ocv,k} + I_k R_{0,k} + U_{p,k} + v_k \end{cases}$$

where $A = \begin{bmatrix} 1 & 0 \\ 0 & \exp(\dfrac{-\Delta t}{\tau_k}) \end{bmatrix}$, $B = \begin{bmatrix} -\dfrac{\Delta t}{Q_n} \\ R_{p,k}[1-\exp(\dfrac{\Delta t}{\tau_k})] \end{bmatrix}$, $R_{0,k}$ represents the ohm internal resistance at time k, $R_{p,k}$ represents the polarization internal resistance at time k, $C_{p,k}$ represents a polarization capacitance at time k, $\tau_k$ = $R_{p,k}C_{p,k}$ represents a time constant at time k, $\omega_k$ represents state noise, and $v_k$ represents measurement noise; updating a noise covariance by using the AEKF algorithm according to the terminal voltage residual in the output result, an updating process being expressed as:

$$H_k = \frac{1}{N} \sum_{k-N+1}^{k} e_k e_k^{\mathrm{T}}, \quad Q_k = G_k H_k G_k^{\mathrm{T}}, \quad R_k = H_k - C_k P_k^{-} C_k^{\mathrm{T}}$$

where $H_k$ represents a mean value of a sum of squares of terminal voltage errors in a sampling window at time k, $Q_k$ represents a process noise covariance at time k, $G_k$ is a Kalman gain at time k, $P_k^{-}$ represents a prediction covariance matrix, $C_k = \begin{bmatrix} -1, & \dfrac{dU_{ocv}(SOC_k)}{dSOC_k} \end{bmatrix}$, $e_k$ represents a residual between an estimated terminal voltage and a measured terminal voltage, and N represents a window length of a residual sequence; determining a first-type maximum SOC corresponding to the maximum cell voltage and a first-type minimum SOC corresponding to the minimum cell voltage by using the Thevenin model; determining a second-type maximum SOC corresponding to the maximum cell voltage and a second-type minimum SOC corresponding to the minimum cell voltage according to the AEKF algorithm and the updated noise covariance; and determining the maximum SOC corresponding to the maximum cell voltage and the minimum SOC corresponding to the minimum cell voltage according to the first-type maximum SOC, the second-type maximum SOC, the first-type minimum SOC, the second-type minimum SOC, and the terminal voltage error corresponding to Thevenin model.

According to the first aspect, in some optional embodiments, the determining an overall SOC of the to-be-tested battery pack according to the maximum SOC and the minimum SOC includes: substituting the maximum SOC and the minimum SOC into a preset formula to obtain the overall SOC, where the preset formula is:

$$SOC_{pack} = w_{soc} SOC_{\max} + (1 - w_{soc}) SOC_{\min}$$

where $SOC_{pack}$ represents the overall SOC, $w_{soc}$ represents a preset weight, $SOC_{\max}$ represents the maximum SOC, and $SOC_{\min}$ represents the minimum SOC.

According to the first aspect, in some optional embodiments, the method further includes: transmitting a prompt message when the overall SOC is less than or equal to a preset value.

In a second aspect, an embodiment of the present application also provides an apparatus for estimating a state of charge (SOC) of a battery, which includes:

a fitting unit, configured to fit a relationship between an open-circuit voltage (OCV) and the SOC based on the OCV corresponding to an SOC range of 0 to 100% for a tested battery pack to obtain an OCV-SOC function;

a creation unit, configured to create a Thevenin model of the tested battery pack based on equivalent circuit parameters of a battery cell in the tested battery pack and the OCV-SOC function;

a detection unit, configured to input real-time parameters acquired from a to-be-tested battery pack into the Thevenin model for detection according to a preset VFF-RLS algorithm with a time-varying forgetting factor to obtain an output result, the output result including a terminal voltage and a terminal voltage residual;

a first determination unit, configured to jointly determine a maximum SOC corresponding to a maximum cell voltage in the real-time parameters and a minimum SOC corresponding to a minimum cell voltage in the real-time parameters based on a preset noise adaptive extended Kalman filter (AEKF) algorithm and the Thevenin model and according to the real-time parameters of the to-be-tested battery pack and the output result; and

a second determination unit, configured to determine an overall SOC of the to-be-tested battery pack according to the maximum SOC and the minimum SOC.

In a third aspect, an embodiment of the present application also provides an electronic device, including a processor and a memory that are coupled to each other, where the memory has a computer program stored therein, and the computer program, when executed by the processor, causes the electronic device to execute the foregoing method.

In a fourth aspect, an embodiment of the present application also provides a battery module, including a module body formed by connecting a plurality of battery cells in series and/or in parallel and the aforementioned electronic device, where the module body is provided with a sensor that is electrically connected with the electronic device, and the sensor is configured to detect electric parameters of each battery cell of the plurality of battery cells.

In a fifth aspect, an embodiment of the present application also provides a computer-readable storage medium having a computer program stored therein, where the computer program, when run on a computer, causes the computer to execute the aforementioned method.

By adopting the above technical solutions, the present application has the following advantages:

In the technical solutions provided by the present application, the real-time parameters acquired from the to-be-tested battery pack are inputted into the Thevenin model for detection according to the preset VFF-RLS algorithm with the time-varying forgetting factor to obtain the output result. The maximum SOC corresponding to the maximum cell voltage in the real-time parameters and the minimum SOC corresponding to the minimum cell voltage in the real-time parameters are jointly determined based on the preset noise adaptive extended Kalman filter (AEKF) algorithm and the Thevenin model and according to the real-time parameters of the to-be-tested battery pack and the output result. Finally, the overall SOC of the to-be-tested battery pack is determined according to the maximum SOC and the minimum SOC. The forgetting factor can be adjusted dynamically by using the VFF-RLS algorithm with the time-varying forgetting factor according to the residual of the battery terminal voltage estimation, thereby enhancing the tracking performance of the algorithm under a dynamic operation condition, and enhancing the online identification stability and reliability of the parameters. Furthermore, the AEKF algorithm may adaptively adjust the process noise covariance and the measurement noise covariance according to the variation of the terminal voltage prediction residual within a certain window length, thereby achieving higher robustness against the current and voltage sampling noise, enabling the SOC estimation process to be more stable, and achieving higher SOC estimation accuracy.

## Brief Description of the Drawings

The present application may be further described by non-restrictive embodiments shown in the accompanying drawings. It should be understood that the following drawings only show some embodiments of the present application, so the embodiments should not be considered as limiting the scope, and for those ordinary skilled in the art, other relevant drawings can also be obtained according to the provided drawings without contributing creative labor.

Fig. 1 is a schematic flowchart of a method for estimating a state of charge (SOC) of a battery provided by an embodiment of the present application.

Fig. 2 is a schematic diagram of a fitted curve of an OCV-SOC function provided by an embodiment of the present application.

Fig. 3 is a schematic diagram of a Thevenin equivalent circuit model provided by an embodiment of the present application.

Fig. 4 is a schematic diagram of an online parameter identification result under a CLTC operation condition provided by an embodiment of the present application.

Fig. 5 is a diagram of a terminal voltage estimation result and error of a Thevenin model under a CLTC operation condition provided by an embodiment of the present application.

Fig. 6 is a diagram of an SOC estimation result and estimation error under a CLTC operation condition provided by an embodiment of the present application.

Fig. 7 is a schematic diagram of a weight for calculating an overall SOC according to a maximum SOC and a minimum SOC under a CLTC operation condition provided by an embodiment of the present application.

## Detailed Description of the Embodiments

The present application is described in detail below with reference to the attached drawings and specific embodiments. It should be noted that in the attached drawings or descriptions, similar or identical parts all use the same reference numerals, and the implementations not shown or described in the attached drawings are known to ordinary technicians in the related art. In the description of the present application, terms "first" and "second" are only for the purpose of differential description, and cannot be understood as indicating or implying relative importance.

An embodiment of the present application provides an electronic device, which may include a processing module and a storage module. Computer programs are stored in the storage module, and when the computer programs are executed by the processing module, the electronic device can execute corresponding operations in the method for estimating the SOC of the battery.

An embodiment of the present application also provides a battery module. The battery module may be used as a power battery in an electric vehicle. The battery module includes a module body and the aforementioned electronic device. The module body is formed by connecting a plurality of battery cells in series and/or in parallel, which is a conventional structure. The battery cell is a single lithium-ion battery or a single cell. The module body is provided with a sensor that is electrically connected with the electronic device.

The sensor is configured to detect electric parameters of each battery cell of the plurality of battery cells. The electric parameters may include a voltage, current, and other data. It may be understood that the sensor may include a current sensor and a voltage sensor. The current sensor may be configured to detect output current of the battery module. The voltage sensor may be configured to detect a real-time voltage of each battery cell.

In the present embodiment, the battery module may detect the SOC of the module body by using the electronic device. When the battery module is applied to the electric vehicle, the accuracy for detecting the SOC is improved. The module body may be used as a to-be-detected battery pack in the following method.

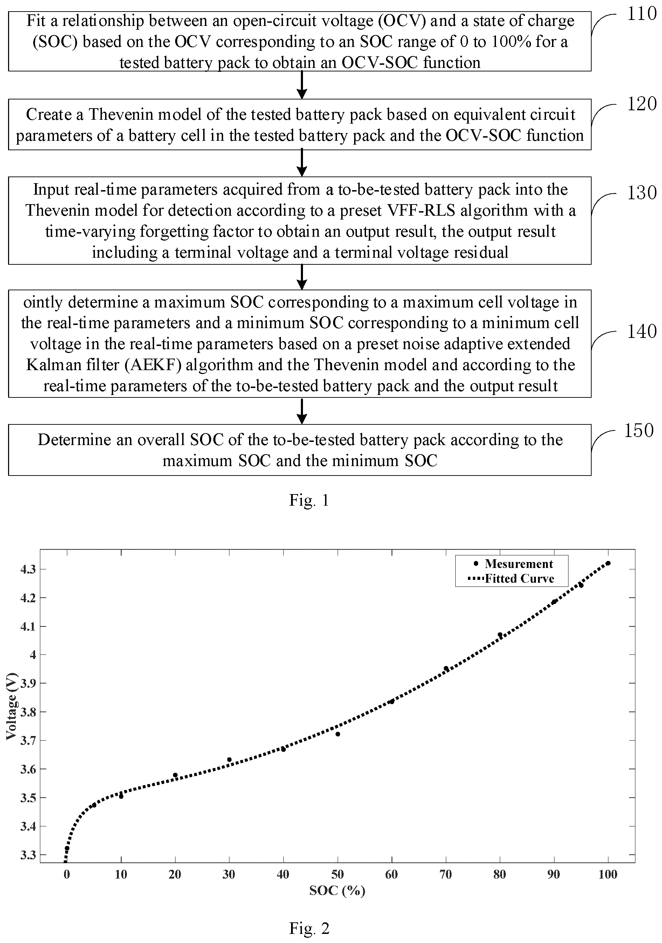

Referring to Fig. 1, the present application also provides a method for estimating an SOC of a battery, which may be applied to the electronic device. Each step of the method is executed or implemented by the electronic device. The method for estimating the SOC of the battery may include the following steps:

In a step 110, a relationship between an open-circuit voltage (OCV) and a SOC is fitted based on the OCV corresponding to an SOC range of 0 to 100% for a tested battery pack to obtain an OCV-SOC function;

In a step 120, a Thevenin model of the tested battery pack is created based on equivalent circuit parameters of a battery cell in the tested battery pack and the OCV-SOC function;

In a step 130, real-time parameters acquired from a to-be-tested battery pack are inputted into the Thevenin model for detection according to a preset VFF-RLS algorithm with a time-varying forgetting factor to obtain an output result, and the output result includes a terminal voltage and a terminal voltage residual;

In a step 140, a maximum SOC corresponding to a maximum cell voltage in the real-time parameters and a minimum SOC corresponding to a minimum cell voltage in the real-time parameters are determined jointly based on a preset noise adaptive extended Kalman filter (AEKF) algorithm and the Thevenin model and according to the real-time parameters of the to-be-tested battery pack and the output result; and

In a step 150, an overall SOC of the to-be-tested battery pack is determined according to the maximum SOC and the minimum SOC.

The steps in the method for estimating the SOC of the battery are described in detail below.

In the step 110, the OCV-SOC function may be expressed as:

$$U_{ocv}(SOC) = aSOC + bSOC^2 + cSOC^3 + d/SOC + e\ln(SOC) + f\ln(1-SOC)$$

where $U_{ocv}$ represents the open-circuit voltage of the battery, *SOC* represents the SOC of the battery, and a, b, c, d, e, and f each represents a fitting coefficient, which may be determined flexibly according to an actual situation.

Fig. 2 is a schematic diagram of a fitted curve of the OCV-SOC function. In the figure, "Measurement" refers to measuring the OCV and the SOC of the to-be-tested battery pack. "Fitted Curve" refers to the fitted curve. The tested battery pack is of a same type and model as the to-be-tested battery pack described below.

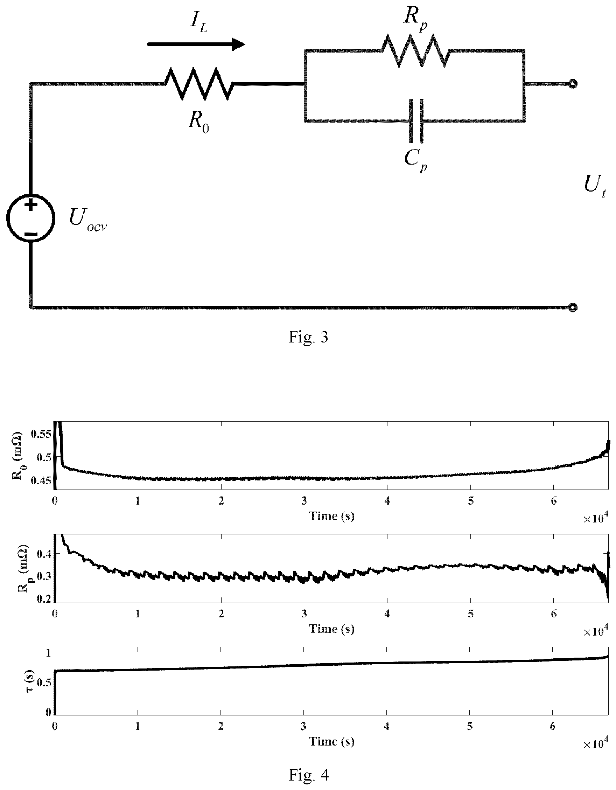

In the step 120, referring to Fig. 3, an equivalent circuit model, i.e., the Thevenin model may be created according to equivalent circuit parameters of the battery cells in the tested battery pack. The equivalent circuit parameters may include, but are not limited to, parameters of the battery cell such as equivalent resistance, and an equivalent voltage. The equivalent circuit parameters are determined in a conventional manner. The Thevenin model may be expressed as:

$$\begin{cases} \dot{U}_p = \dfrac{I}{C_p} - \dfrac{U_p}{R_p C_p} \\ U_t = U_{ocv} - IR_0 - U_p \end{cases} \tag{1}$$

where $U_p$ represents a polarization voltage of the battery, $I$ represents current, $R_0$ represents ohm internal resistance, $R_p$ represents polarization internal resistance, $C_p$ represents a polarization capacitance, $U_t$ represents the terminal voltage of the battery, and $U_{ocv}$ represents the open-circuit voltage of the battery.

In the step 130, the VFF-RLS algorithm refers to a recursive least squares (RLS) algorithm with the time-varying forgetting factor. The electronic device identifies the parameters such as the open-circuit voltage $U_{ocv}$, the ohm internal resistance $R_0$, the polarization internal resistance $R_p$, and the polarization capacitance $C_p$ in the Thevenin model by using the VFF-RLS algorithm with the time-varying forgetting factor. An identification result is substituted into the Thevenin model to output the terminal voltage and the terminal voltage residual. The identification result includes the identified parameters such as the open-circuit voltage $U_{ocv}$, the ohm internal resistance $R_0$, the polarization internal resistance $R_p$, and the polarization capacitance $C_p$.

The VFF-RLS algorithm based on the time-varying forgetting factor may dynamically adjust the forgetting factor according to the residual of the battery terminal voltage estimation, thereby enhancing the tracking performance of the recursive least squares (referring to the RLS algorithm) under a dynamic operation condition, and enhancing the online identification stability and reliability of the parameters.

In the present embodiment, the step 130 may include:

Laplace transform is performed on the Thevenin model to obtain a system transfer function as follows:

$$G(s) = \frac{U_t(s) - U_{ocv}(s)}{I(s)} = -\frac{R_0 + R_p + R_0 R_p C_p s}{1 + R_p C_p s} \tag{2}$$

where $U_t(s)$ represents the terminal voltage in the transfer function, and s represents a complex variable in the Laplace transform;

bilinear transform is performed on the transfer function $G(s)$, and the transfer function is mapped to a z-plane to obtain:

$$G(z^{-1}) = -\frac{\dfrac{R_0 + R_p + 2R_0 R_p C_p}{1 + 2R_p C_p} + \dfrac{R_0 + R_p - 2R_0 R_p C_p}{1 + 2R_p C_p} z^{-1}}{1 + \dfrac{1 - 2R_p C_p}{1 + 2R_p C_p} z^{-1}} \tag{3}$$

a mathematical expression of the Thevenin model is transformed to obtain:

$$E_k = U_{ocv,k} - U_{t,k} = a_1 E_{k-1} - R_0 I_k - [(1 - a_1)R_p I_{k-1} - a_1 R_0 I_{k-1}] = a_1 E_{k-1} + a_2 I_k + a_3 I_{k-1}$$

$$(4)$$

where $E_k$ represents an ohm voltage drop and a polarization voltage drop of the battery at time k, $U_{ocv,k}$ represents the open-circuit voltage at time k, $U_{t,k}$ represents a real-time voltage acquired from the to-be-tested battery pack at time k,

and $I_k$ represents real-time current acquired from the to-be-tested battery pack at time k;

based on the transfer function $G(s)$, parameters $a_1$, $a_2$, and $a_3$ are expressed by using the parameters of the Thevenin model as:

$$\begin{cases} a_1 = \dfrac{1-2R_pC_p}{1+2R_pC_p} \\[2mm] a_2 = -\dfrac{R_0+R_p+2R_pC_p}{1+2R_pC_p} \\[2mm] a_3 = -\dfrac{R_0+R_p-2R_pC_p}{1+2R_pC_p} \end{cases} \tag{5}$$

a to-be-identified system $y_k = \varphi_k \theta_k^T$ is established,

where $y_k$ represents an output of the to-be-identified system, $\varphi_k = [E_{k-1}, I_k, I_{k-1}]$ represents an input vector of the to-be-identified system, and $\theta_k = [a_{1,k}, a_{2,k}, a_{3,k}]$ represents a parameter vector;

the time-varying forgetting factor $\lambda_k$ is introduced into an observation variance matrix for correction, where the observation variance matrix refers to an intermediate matrix in an iterative operation process, which is well known to those skilled in the art; and furthermore, $\lambda_k$ may be expressed as:

$$\lambda_k = \lambda_{\min} + (1-\lambda_{\min})^{\beta_k} \tag{6}$$

where $\beta_k = 2^{\rho e_k^2}$, $\lambda_{\min}$ represents a lower limit value of the time-varying forgetting factor $\lambda_k$, $\rho$ is a parameter for adjusting the time-varying forgetting factor $\lambda_k$, and $e_k$ represents the terminal voltage residual identified by using the VFF-RLS algorithm at time k; and in the time-varying forgetting factor, the corresponding parameters may be valued as: $\lambda_{\min} = 0.95$, $\lambda_k \in [0.95,1]$, and $\rho = 0.5$;

the Thevenin model is identified according to the VFF-RLS algorithm and the real-time parameters to obtain an identification result, and the identification result includes the ohm internal resistance $R_0$, the polarization internal resistance $R_p$, and a time constant $\tau = R_pC_p$; and

the identification result is substituted into the Thevenin model to obtain the output result including the terminal voltage and the terminal voltage residual.

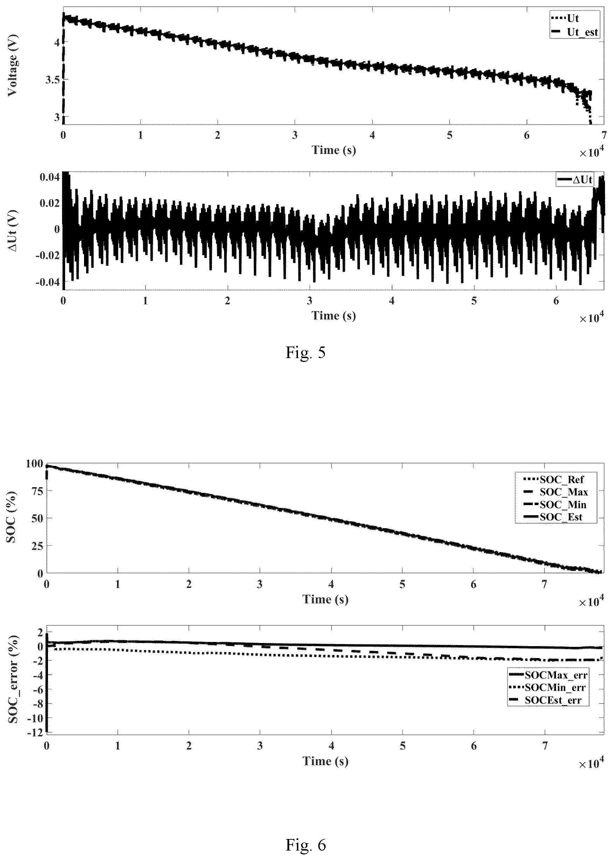

For example, the identification result may be as shown in Fig. 4. The terminal voltage and the terminal voltage residual may be as shown in Fig. 5. In Fig. 5, $\Delta U_t(V)$ refers to the terminal voltage residual or a terminal voltage error.
In the step 140, by acquiring the maximum cell voltage, the minimum cell voltage, and the current inside the battery pack in real time, the two maximum SOCs and the two minimum SOCs may be calculated separately based on the Thevenin model and the ampere-hour integral. Subsequently, the two maximum SOCs and the two minimum SOCs are fused by using the AEKF algorithm according to the terminal voltage error calculated by the Thevenin model to obtain the maximum SOC and the minimum SOC that are closer to true values. By fusing the maximum SOC and the minimum SOC calculated by using the Thevenin model and the AEKF algorithm, the reliability of the calculated SOC is improved.
In a case that an initial value of the SOC has an error, the SOC estimation result and error under the China light-duty vehicle test cycle (CLTC) operation condition may be as shown in Fig. 6.
In the present embodiment, the state noise covariance $Q_k$ and the measurement covariance $R_k$ may be adaptively adjusted by using the AEKF algorithm according to a real-time estimated terminal voltage residual sequence in an iteration process.
For example, the step 140 may include:

a battery SOC calculation formula based on an ampere-hour integral is established, and expressed as:

$$SOC_{k+1} = SOC_0 + \int_0^k \frac{\eta I \Delta t}{Q_n} \tag{7}$$

where $SOC_{k+1}$ represents the SOC at time k+1, $SOC_0$ represents an initial value of the SOC of the battery, $\eta$ represents a Coulomb coefficient, $I$ represents acquired real-time current, $\Delta t$ represents a sampling period, and $Q_n$ represents a rated capacity of the battery;

a system discrete state-space equation is established based on the output result of the Thevenin model and the SOC calculated by using the ampere-hour integral, a system state variable is $x = (SOC, U_p)$, an input is $u = I$, an output is $y = U_t$, and the space equation is expressed as:

$$\begin{cases} \begin{bmatrix} SOC_{k+1} \\ U_{p,k+1} \end{bmatrix} = A \begin{bmatrix} SOC_k \\ U_{p,k} \end{bmatrix} + BI_k + \omega_k \\ U_{t,k+1} = U_{ocv,k} + I_k R_{0,k} + U_{p,k} + v_k \end{cases} \tag{8}$$

where $A = \begin{bmatrix} 1 & 0 \\ 0 & \exp(\frac{-\Delta t}{\tau_k}) \end{bmatrix}$, $B = \begin{bmatrix} -\dfrac{\Delta t}{Q_n} \\ R_{p,k}[1 - \exp(\frac{\Delta t}{\tau_k})] \end{bmatrix}$, $R_{0,k}$ represents the ohm internal resistance at time k, $R_{p,k}$ represents the polarization internal resistance at time k, $C_{p,k}$ represents a polarization capacitance at time k, $\tau_k = R_{p,k}C_{p,k}$ represents a time constant at time k, $\omega_k$ represents state noise, and $v_k$ represents measurement noise; the noise covariance is updated by using the AEKF algorithm according to the terminal voltage residual in the output result, and an updating process is expressed as:

$$H_k = \frac{1}{N} \sum_{k-N+1}^k e_k e_k^{\mathrm{T}}, \quad Q_k = G_k H_k G_k^{\mathrm{T}}, \quad R_k = H_k - C_k P_k^- C_k^{\mathrm{T}} \tag{9}$$

where $H_k$ represents a mean value of a sum of squares of terminal voltage errors in a sampling window at time k, $Q_k$ represents a process noise covariance at time k, $G_k$ is a Kalman gain at time k, $P_k^-$ represents a prediction covariance matrix, $C_k = \begin{bmatrix} -1, \dfrac{dU_{ocv}(SOC_k)}{dSOC_k} \end{bmatrix}$, $e_k$ represents a residual between estimated terminal voltage and measured terminal voltage, and $N$ represents a window length of a residual sequence;

a first-type maximum SOC corresponding to the maximum cell voltage and a first-type minimum SOC corresponding to the minimum cell voltage are determined by using the Thevenin model;

a second-type maximum SOC corresponding to the maximum cell voltage and a second-type minimum SOC corresponding to the minimum cell voltage are determined according to the AEKF algorithm and the updated noise covariance; and

the maximum SOC corresponding to the maximum cell voltage and the minimum SOC corresponding to the minimum cell voltage are determined according to the first-type maximum SOC, the second-type maximum SOC, the first-type minimum SOC, the second-type minimum SOC, and the terminal voltage error corresponding to Thevenin model.

Compared with the conventional method using a single ampere-hour integral method for SOC calculation, the method provided by the present application incorporates the battery equivalent circuit model and measurement information for closed-loop calculation, so that the SOC error can be iteratively corrected online, and the robustness is higher. Furthermore, compared with the conventional method based on the extended Kalman filter (EKF) algorithm, the AEKF algorithm in the present application may adaptively adjust the state noise covariance $Q_k$ and the measurement covariance $R_k$ according to the variation of the terminal voltage prediction residual within a certain window length, thereby achieving higher robustness against the current and voltage sampling noise, enabling the SOC estimation process to be more stable, and achieving higher SOC estimation accuracy.

The step 150 may include: the maximum SOC and the minimum SOC are substituted into a preset formula to obtain the overall SOC, where the preset formula is:

$$SOC_{pack} = w_{soc}SOC_{\max} + (1 - w_{soc})SOC_{\min} \qquad (10)$$

where $SOC_{pack}$ represents the overall SOC, $w_{soc}$ represents a preset weight, $SOC_{\max}$ represents the maximum SOC, and $SOC_{\min}$ represents the minimum SOC.

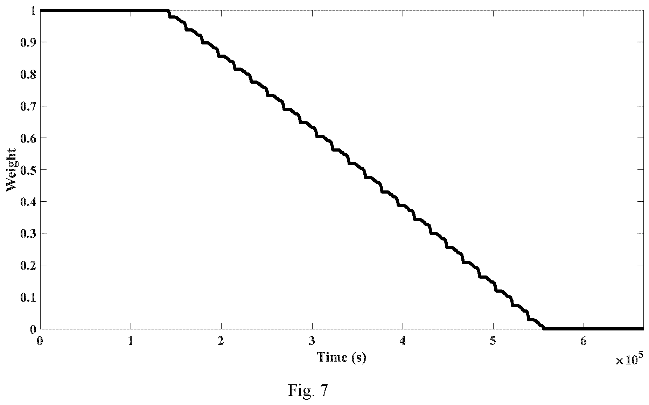

Under the CLTC operation condition, a calculation result of the weight $w_{soc}$ may be as shown in Fig. 7.

In the present embodiment, a test cycle for battery calibration matching during the development of the battery pack is shortened, and the problem of poor SOC estimation accuracy caused by battery model mismatch after the aging and parameter deviations from offline test samples is solved, thereby improving the estimation accuracy of the overall SOC of a power battery of the new energy vehicle.

As an optional embodiment, the method may further include:

a prompt message is transmitted when the overall SOC is less than or equal to a preset value.

The preset value may be determined flexibly according to the actual situation. For example, the preset value may be 20%. For example, when the to-be-tested battery pack is a battery pack in the electric vehicle, and when the detected overall SOC of the to-be-tested battery pack is less than or equal to 20%, the prompt message indicating low power of the battery is transmitted to prompt a vehicle owner to charge the vehicle in time.

The present application further provides an apparatus for estimating a state of charge (SOC) of a battery. The apparatus for estimating the SOC of the battery includes at least one software functional module that may be stored in a storage module or fixed in an operating system (OS) in a software form or firmware form. A processing module is configured to execute an executable module stored in the storage module, such as the software functional module and a computer program included by the apparatus for estimating the SOC of the battery.

The apparatus for estimating the SOC of the battery includes a fitting unit, a creation unit, a detection unit, a first determination unit, and a second determination unit. Each unit may have the following functions:

The fitting unit is configured to fit a relationship between an open-circuit voltage (OCV) and the SOC based on the OCV corresponding to an SOC range of 0 to 100% for a tested battery pack to obtain an OCV-SOC function;

The creation unit is configured to create a Thevenin model of the tested battery pack based on equivalent circuit parameters of a battery cell in the tested battery pack and the OCV-SOC function;

The detection unit is configured to input real-time parameters acquired from a to-be-tested battery pack into the Thevenin model for detection according to a preset VFF-RLS algorithm with a time-varying forgetting factor to obtain an output result, and the output result includes a terminal voltage and a terminal voltage residual;

The first determination unit is configured to jointly determine a maximum SOC corresponding to a maximum cell voltage in the real-time parameters and a minimum SOC corresponding to a minimum cell voltage in the real-time parameters based on a preset noise adaptive extended Kalman filter (AEKF) algorithm and the Thevenin model and according to the real-time parameters of the to-be-tested battery pack and the output result; and

The second determination unit is configured to determine an overall SOC of the to-be-tested battery pack according to the maximum SOC and the minimum SOC.

Optionally, the detection unit is configured to:

perform Laplace transform on the Thevenin model to obtain a system transfer function as follows:

$$G(s) = \frac{U_t(s) - U_{ocv}(s)}{I(s)} = -\frac{R_0 + R_p + R_0 R_p C_p s}{1 + R_p C_p s}$$

where $U_t(s)$ represents the terminal voltage in the transfer function, and s represents a complex variable in the Laplace transform;

perform bilinear transform on the transfer function $G(s)$, and map the transfer function to a z-plane to obtain:

$$G(z^{-1}) = -\cfrac{\cfrac{R_0 + R_p + 2R_0 R_p C_p}{1 + 2R_p C_p} + \cfrac{R_0 + R_p - 2R_0 R_p C_p}{1 + 2R_p C_p} z^{-1}}{1 + \cfrac{1 - 2R_p C_p}{1 + 2R_p C_p} z^{-1}}$$

transform a mathematical expression of the Thevenin model to obtain:

$$E_k = U_{ocv,k} - U_{t,k} = a_1 E_{k-1} - R_0 I_k - [(1 - a_1)R_p I_{k-1} - a_1 R_0 I_{k-1}] = a_1 E_{k-1} + a_2 I_k + a_3 I_{k-1}$$

where $E_k$ represents an ohm voltage drop and a polarization voltage drop of the battery at time k, $U_{ocv,k}$ represents the open-circuit voltage at time k, $U_{t,k}$ represents a real-time voltage acquired from the to-be-tested battery pack at time k, and $I_k$ represents real-time acquired from the to-be-tested battery pack at time k;

express, by using the parameters of the Thevenin model, parameters $a_1$, $a_2$, and $a_3$ based on the transfer function G(s) as:

$$\begin{cases} a_1 = \dfrac{1 - 2R_p C_p}{1 + 2R_p C_p} \\[4mm] a_2 = -\dfrac{R_0 + R_p + 2R_p C_p}{1 + 2R_p C_p} \\[4mm] a_3 = -\dfrac{R_0 + R_p - 2R_p C_p}{1 + 2R_p C_p} \end{cases}$$

establish a to-be-identified system $y_k = \varphi_k \theta_k^T$,

where $y_k$ represents an output of the to-be-identified system, $\varphi_k = [E_{k-1}, I_k, I_{k-1}]$ represents an input vector of the to-be-identified system, and $\theta_k = [a_{1,k}, a_{2,k}, a_{3,k}]$ represents a parameter vector;

introduce the time-varying forgetting factor $\lambda_k$ into an observation variance matrix for correction, $\lambda_k$ being expressed as:

$$\lambda_k = \lambda_{min} + (1 - \lambda_{min})^{\beta_k}$$

where $\beta_k = 2^{\rho e_k^2}$, $\lambda_{min}$ represents a lower limit value of the time-varying forgetting factor $\lambda_k$, $\rho$ is a parameter for adjusting the time-varying forgetting factor $\lambda_k$, and $e_k$ represents the terminal voltage residual identified by using the VFF-RLS algorithm at time k;

identify the Thevenin model according to the VFF-RLS algorithm and the real-time parameters to obtain an identification result, the identification result including the ohm internal resistance $R_0$, the polarization internal resistance $R_p$, and a time constant $\tau = R_p C_p$; and

substitute the identification result into the Thevenin model to obtain the output result including the terminal voltage and the terminal voltage residual.

Optionally, the first determination unit is configured to:

establish a battery SOC calculation formula based on an ampere-hour integral, which is expressed as:

$$SOC_{k+1} = SOC_0 + \int_0^k \frac{\eta I \Delta t}{Q_n}$$

where $SOC_{k+1}$ represents the SOC at time k+1, $SOC_0$ represents an initial value of the SOC of the battery, $\eta$ represents a Coulomb coefficient, $I$ represents acquired real-time current, $\Delta t$ represents a sampling period, and $Q_n$

represents a rated capacity of the battery;

establish a system discrete state-space equation based on the output result of the Thevenin model and the SOC calculated by using the ampere-hour integral, a system state variable being $x = (SOC, U_p)$, an input being $u = I$, an output being $y = U_t$, and the space equation being expressed as:

$$\begin{cases} \begin{bmatrix} SOC_{k+1} \\ U_{p,k+1} \end{bmatrix} = A \begin{bmatrix} SOC_k \\ U_{p,k} \end{bmatrix} + BI_k + \omega_k \\ U_{t,k+1} = U_{ocv,k} + I_k R_{0,k} + U_{p,k} + v_k \end{cases}$$

where $A = \begin{bmatrix} 1 & 0 \\ 0 & \exp(\dfrac{-\Delta t}{\tau_k}) \end{bmatrix}$, $B = \begin{bmatrix} -\dfrac{\Delta t}{Q_n} \\ R_{p,k}[1 - \exp(\dfrac{\Delta t}{\tau_k})] \end{bmatrix}$, $R_{0,k}$ represents the ohm internal resistance at time k, $R_{p,k}$ represents the polarization internal resistance at time k, $C_{p,k}$ represents a polarization capacitance at time k, $\tau_k = R_{p,k}C_{p,k}$ represents a time constant at time k, $\omega_k$ represents state noise, and $v_k$ represents measurement noise;

update a noise covariance by using the AEKF algorithm according to the terminal voltage residual in the output result, an updating process being expressed as:

$$H_k = \frac{1}{N} \sum_{k-N+1}^{k} e_k e_k^{\mathrm{T}}, \quad Q_k = G_k H_k G_k^{\mathrm{T}}, \quad R_k = H_k - C_k P_k^- C_k^{\mathrm{T}}$$

where $H_k$ represents a mean value of a sum of squares of terminal voltage errors in a sampling window at time k, $Q_k$ represents a process noise covariance at time k, $G_k$ is a Kalman gain at time k, $P_k^-$ represents a prediction covariance matrix, $C_k = \begin{bmatrix} -1, \dfrac{dU_{ocv}(SOC_k)}{dSOC_k} \end{bmatrix}$, $e_k$ represents a residual between estimated terminal voltage and measured terminal voltage, and $N$ represents a window length of a residual sequence;

determine a first-type maximum SOC corresponding to the maximum cell voltage and a first-type minimum SOC corresponding to the minimum cell voltage by using the Thevenin model;

determine a second-type maximum SOC corresponding to the maximum cell voltage and a second-type minimum SOC corresponding to the minimum cell voltage according to the AEKF algorithm and the updated noise covariance; and

determine the maximum SOC corresponding to the maximum cell voltage and the minimum SOC corresponding to the minimum cell voltage according to the first-type maximum SOC, the second-type maximum SOC, the first-type minimum SOC, the second-type minimum SOC, and the terminal voltage error corresponding to Thevenin model.

Optionally, the second determination unit is configured to:
substitute the maximum SOC and the minimum SOC into a preset formula to obtain the overall SOC, where the preset formula is:

$$SOC_{pack} = w_{soc} SOC_{\max} + (1 - w_{soc}) SOC_{\min}$$

where $SOC_{pack}$ represents the overall SOC, $w_{soc}$ represents a preset weight, $SOC_{\max}$ represents the maximum SOC, and

$SOC_{min}$ represents the minimum SOC.

Optionally, the apparatus for estimating the SOC of the battery may also include a prompting unit that is configured to transmit a prompt message when the overall SOC is less than or equal to a preset value.

In the present embodiment, the processing module may be an integrated circuit chip with a signal processing capability. The processing module may be a general processor. For example, the processor may be a central processing unit (CPU), a digital signal processor (DSP), an application specific integrated circuit (ASIC), a field-programmable gate array (FPGA) or other programmable logic devices, discrete gate or transistor logic devices, discrete hardware components, etc., which may implement or execute various methods, steps, and logic block diagrams disclosed in the embodiments of the present application.

The storage module may be, but is not limited to, a random access memory, a read-only memory, a programmable read-only memory, an erasable programmable read-only memory, an electric erasable programmable read-only memory, or the like. In the present embodiment, the storage module may be configured to store the real-time parameters of the to-be-tested battery pack, the preset AEKF algorithm, the created Thevenin model, the preset value of the to-be-tested battery pack, and the like. Certainly, the storage module may also be configured to store a program. The processing module executes the program after receiving an execution instruction.

It should be noted that those skilled in the art may clearly learn about that for the convenience and brevity of description, the specific operation process of the above electronic device may refer to the corresponding processes of the steps in the aforementioned method, which is not repeated here.

An embodiment of the present application further provides a computer-readable storage medium. The computer-readable storage medium has a computer program stored therein, and the computer program, when run on a computer, causes the computer to execute the method for estimating the SOC of the battery in the aforementioned embodiments.

Through the description of the above embodiments, those skilled in the art can clearly understand that the present application can be implemented by hardware, or by means of software and necessary general hardware platforms. Based on this understanding, the technical solutions of the present application can be embodied in a form of software products. The software product can be stored in a non-volatile storage medium (such as CD-ROM, USB flash disks, mobile hard disks, etc.), including a plurality of instructions for making a computer device (which may be a personal computer, an electronic device, or a network device, etc.) execute the methods described in various embodiment scenarios of the present application.

In conclusion, the embodiments of the present application provide the method and apparatus for estimating the SOC of the battery, and the device, the battery module, and the storage medium. In the present solution, the method includes: based on the OCV corresponding to an SOC range of 0 to 100% for the tested battery pack, the relationship between the OCV and the SOC is fitted to obtain the OCV-SOC function; based on the equivalent circuit parameters of the battery cell in the tested battery pack and the OCV-SOC function, the Thevenin model of the tested battery pack is created; according to the preset VFF-RLS algorithm with the time-varying forgetting factor, the real-time parameters acquired from the to-be-tested battery pack are inputted into the Thevemin model for detection to obtain the output result, and the output result includes the terminal voltage and the terminal voltage residual; based on the preset noise adaptive extended Kaman filter (AEKF) algorithm and the Thevenin model, and according to the real-time parameters of the to-be-tested battery pack and the output result, the maximum SOC corresponding to the maximum cell voltage in the real-time parameters, and the minimum SOC corresponding to the minimum cell voltage in the real-time parameters are determinedly jointly; and according to the maximum SOC and the minimum SOC, the overall SOC of the to-be-tested battery pack is determined.

The forgetting factor can be adjusted dynamically by using the VFF-RLS algorithm with the time-varying forgetting factor according to the residual of the battery terminal voltage estimation, thereby enhancing the tracking performance of the algorithm under the dynamic operation condition, and enhancing the online identification stability and reliability of the parameters. Furthermore, the AEKF algorithm may adaptively adjust the process noise covariance and the measurement noise covariance according to the variation of the terminal voltage prediction residual within a certain window length, thereby achieving higher robustness against the current and voltage sampling noise, enabling the SOC estimation process to be more stable, and achieving higher SOC estimation accuracy.

In the embodiments provided in the present application, it should be understood that the disclosed apparatus, system, and method may also be implemented in other ways. The apparatus, system, and method embodiments described above are merely illustrative. For example, the flowcharts and block diagrams in the accompanying drawings illustrate system architectures, functions, and operations that may be implemented by the system, method, and a computer program product according to the embodiments of the present application. Each box in a flowchart or a block diagram may represent a module, a program segment, or a part of code. The module, the program segment, or the part of code includes one or more executable instructions configured for implementing specified logic functions. It should also be noted that each block in the block diagram and/or flowchart, and combinations of blocks in the block diagram and/or flowchart, may be implemented by dedicated hardware-based systems performing the specified functions or acts, or by combinations of dedicated hardware and computer instructions. Furthermore, all functional modules in various embodiments of the present application may be integrated into an independent part, or may be physically separated, or two or more of the functional modules may be integrated into an independent part.

The above description is only embodiments of the present application and is not used to limit the scope of protection of the present application. For those skilled in the art, various changes and variations of the present application can be made. Any modifications, equivalent substitution and improvements made within the spirit and principle of the present application shall be contained within the protection scope of the present application.

**Claims**

1. A method for estimating a state of charge (SOC) of a battery, comprising:

   fitting a relationship between open-circuit voltage (OCV) and the SOC based on the OCV corresponding to an SOC range of 0 to 100% for a tested battery pack to obtain an OCV-SOC function;
   creating a Thevenin model of the tested battery pack based on equivalent circuit parameters of a battery cell in the tested battery pack and the OCV-SOC function;
   inputting real-time parameters acquired from a to-be-tested battery pack into the Thevenin model for detection according to a preset VFF-RLS algorithm with a time-varying forgetting factor to obtain an output result, the output result comprising a terminal voltage and a terminal voltage residual;
   jointly determining a maximum SOC corresponding to maximum cell voltage in the real-time parameters and a minimum SOC corresponding to minimum cell voltage in the real-time parameters based on a preset noise adaptive extended Kalman filter (AEKF) algorithm and the Thevenin model and according to the real-time parameters of the to-be-tested battery pack and the output result; and
   determining an overall SOC of the to-be-tested battery pack according to the maximum SOC and the minimum SOC.

2. The method according to claim 1, wherein the OCV-SOC function is expressed as:

$$U_{ocv}(SOC)=aSOC+bSOC^2+cSOC^3+d/SOC+e\ln(SOC)+f\ln(1-SOC)$$

   wherein $U_{ocv}$ represents the open-circuit voltage of the battery, $SOC$ represents the state of charge of the battery, and a, b, c, d, e, and f each represents a fitting coefficient.

3. The method according to claim 1, wherein the Thevenin model is expressed as:

$$\begin{cases} \dot{U}_p = \dfrac{I}{C_p} - \dfrac{U_p}{R_p C_p} \\ U_t = U_{ocv} - IR_0 - U_p \end{cases}$$

   wherein $U_p$ represents a polarization voltage of the battery, $I$ represents current, $R_0$ represents ohm internal resistance, $R_p$ represents polarization internal resistance, $C_p$ represents a polarization capacitance, $U_t$ represents the terminal voltage of the battery, and $U_{ocv}$ represents the open-circuit voltage of the battery.

4. The method according to claim 3, wherein the inputting real-time parameters acquired from a to-be-tested battery pack into the Thevenin model for detection according to a preset VFF-RLS algorithm with a time-varying forgetting factor to obtain an output result comprises:

   performing Laplace transform on the Thevenin model to obtain a system transfer function as follows:

$$G(s) = \frac{U_t(s) - U_{ocv}(s)}{I(s)} = -\frac{R_0 + R_p + R_0 R_p C_p s}{1 + R_p C_p s}$$

   wherein $U_t(s)$ represents the terminal voltage in the transfer function, and s represents a complex variable in the Laplace transform;
performing bilinear transform on the transfer function $G(s)$, and mapping the transfer function to a z-plane to obtain:

$$G(z^{-1}) = -\frac{\dfrac{R_0 + R_p + 2R_0R_pC_p}{1+2R_pC_p} + \dfrac{R_0 + R_p - 2R_0R_pC_p}{1+2R_pC_p}z^{-1}}{1+\dfrac{1-2R_pC_p}{1+2R_pC_p}z^{-1}}$$

transforming a mathematical expression of the Thevenin model to obtain:

$$E_k = U_{ocv,k} - U_{t,k} = a_1 E_{k-1} - R_0 I_k - [(1-a_1)R_pI_{k-1} - a_1R_0I_{k-1}] = a_1E_{k-1} + a_2I_k + a_3I_{k-1}$$

wherein $E_k$ represents an ohm voltage drop and a polarization voltage drop of the battery at time k, $U_{ocv,k}$ represents the open-circuit voltage at time k, $U_{t,k}$ represents real-time voltage acquired from the to-be-tested battery pack at time k, and $I_k$ represents real-time current acquired from the to-be-tested battery pack at time k; expressing, by using the parameters of the Thevenin model, parameters $a_1$, $a_2$, and $a_3$ based on the transfer function $G(s)$ as:

$$\begin{cases} a_1 = \dfrac{1-2R_pC_p}{1+2R_pC_p} \\[3mm] a_2 = -\dfrac{R_0 + R_p + 2R_pC_p}{1+2R_pC_p} \\[3mm] a_3 = -\dfrac{R_0 + R_p - 2R_pC_p}{1+2R_pC_p} \end{cases}$$

establishing a to-be-identified system $y_k = \varphi_k \theta_k^T$
wherein $y_k$ represents an output of the to-be-identified system, $\varphi_k = [E_{k-1}, I_k, I_{k-1}]$ represents an input vector of the to-be-identified system, and $\theta_k = [a_{1,k}, a_{2,k}, a_{3,k}]$ represents a parameter vector;
introducing the time-varying forgetting factor $\lambda_k$ into an observation variance matrix for correction, $\lambda_k$ being expressed as:

$$\lambda_k = \lambda_{\min} + (1-\lambda_{\min})^{\beta_k}$$

wherein $\beta_k = 2^{\rho e_k^2}$, $\lambda_{\min}$ represents a lower limit value of the time-varying forgetting factor $\lambda_k$, $P$ is a parameter for adjusting the time-varying forgetting factor $\lambda_k$, and $e_k$ represents the terminal voltage residual identified by using the VFF-RLS algorithm at time k;
identifying the Thevenin model according to the VFF-RLS algorithm and the real-time parameters to obtain an identification result, the identification result comprising the ohm internal resistance $R_0$, the polarization internal resistance $R_p$, and a time constant $\tau = R_pC_p$; and
substituting the identification result into the Thevenin model to obtain the output result comprising the terminal voltage and the terminal voltage residual.

5. The method according to claim 4, wherein in the time-varying forgetting factor, $\lambda_{\min} = 0.95$, $\lambda_k \in [0.95, 1]$, and $\rho = 0.5$.

6. The method according to claim 4, wherein the jointly determining a maximum SOC corresponding to maximum cell voltage in the real-time parameters and a minimum SOC corresponding to minimum cell voltage in the real-time parameters based on a preset noise adaptive extended Kalman filter (AEKF) algorithm and the Thevenin model and according to the real-time parameters of the to-be-tested battery pack and the output result comprises:

establishing a battery SOC calculation formula based on an ampere-hour integral, the formula being expressed as:

$$SOC_{k+1} = SOC_0 + \int_0^k \frac{\eta I \Delta t}{Q_n}$$

wherein $SOC_{k+1}$ represents the SOC at time k+1, $SOC_0$ represents an initial value of the SOC of the battery, $\eta$ represents a Coulomb coefficient, $I$ represents acquired real-time current, $\Delta t$ represents a sampling period, and $Q_n$ represents a rated capacity of the battery;

establishing a system discrete state-space equation based on the output result of the Thevenin model and the SOC calculated by using the ampere-hour integral, a system state variable being $x = (SOC, U_p)$, an input being $u = I$, an output being $y = U_t$, and the space equation being expressed as:

$$\begin{cases} \begin{bmatrix} SOC_{k+1} \\ U_{p,k+1} \end{bmatrix} = A \begin{bmatrix} SOC_k \\ U_{p,k} \end{bmatrix} + BI_k + \omega_k \\ U_{t,k+1} = U_{ocv,k} + I_k R_{0,k} + U_{p,k} + v_k \end{cases}$$

wherein $A = \begin{bmatrix} 1 & 0 \\ 0 & \exp(\frac{-\Delta t}{\tau_k}) \end{bmatrix}$, $B = \begin{bmatrix} -\dfrac{\Delta t}{Q_n} \\ R_{p,k}[1 - \exp(\frac{\Delta t}{\tau_k})] \end{bmatrix}$, $R_{0,k}$ represents the ohm internal resistance at time k, $R_{p,k}$ represents the polarization internal resistance at time k, $C_{p,k}$ represents a polarization capacitance at time k, $\tau_k = R_{p,k}C_{p,k}$ represents a time constant at time k, $\omega_k$ represents state noise, and $v_k$ represents measurement noise;

updating a noise covariance by using the AEKF algorithm according to the terminal voltage residual in the output result, an updating process being expressed as:

$$H_k = \frac{1}{N} \sum_{k-N+1}^{k} e_k e_k^{\mathrm{T}}, \quad Q_k = G_k H_k G_k^{\mathrm{T}}, \quad R_k = H_k - C_k P_k^- C_k^{\mathrm{T}}$$

wherein $H_k$ represents a mean value of a sum of squares of terminal voltage errors in a sampling window at time k, $Q_k$ represents a process noise covariance at time k, $G_k$ is a Kalman gain at time k, $P_k^-$ represents a prediction covariance matrix, $C_k = \begin{bmatrix} -1, & \dfrac{dU_{ocv}(SOC_k)}{dSOC_k} \end{bmatrix}$, $e_k$ represents a residual between estimated terminal voltage and measured terminal voltage, and N represents a window length of a residual sequence;

determining a first-type maximum SOC corresponding to the maximum cell voltage and a first-type minimum SOC corresponding to the minimum cell voltage by using the Thevenin model;

determining a second-type maximum SOC corresponding to the maximum cell voltage and a second-type minimum SOC corresponding to the minimum cell voltage according to the AEKF algorithm and the updated noise covariance; and

determining the maximum SOC corresponding to the maximum cell voltage and the minimum SOC corresponding to the minimum cell voltage according to the first-type maximum SOC, the second-type maximum SOC, the first-type minimum SOC, the second-type minimum SOC, and a terminal voltage error corresponding to Thevenin model.

7. The method according to claim 1, wherein the determining an overall SOC of the to-be-tested battery pack according to the maximum SOC and the minimum SOC comprises:
substituting the maximum SOC and the minimum SOC into a preset formula to obtain the overall SOC, wherein the preset formula is:

$$SOC_{pack} = w_{soc}SOC_{\max} + (1 - w_{soc})SOC_{\min}$$

wherein $SOC_{pack}$ represents the overall SOC, $w_{soc}$ represents a preset weight, $SOC_{\max}$ represents the maximum SOC, and $SOC_{\min}$ represents the minimum SOC.

8. The method according to any one of claims 1 to 7, wherein the method further comprises:
transmitting a prompt message when the overall SOC is less than or equal to a preset value.

9. An apparatus for estimating a state of charge (SOC) of a battery, comprising:

a fitting unit, configured to fit a relationship between open-circuit voltage (OCV) and the SOC based on the OCV corresponding to an SOC range of 0 to 100% for a tested battery pack to obtain an OCV-SOC function;
a creation unit, configured to create a Thevenin model of the tested battery pack based on equivalent circuit parameters of a battery cell in the tested battery pack and the OCV-SOC function;
a detection unit, configured to input real-time parameters acquired from a to-be-tested battery pack into the Thevenin model for detection according to a preset VFF-RLS algorithm with a time-varying forgetting factor to obtain an output result, the output result comprising terminal voltage and a terminal voltage residual;
a first determination unit, configured to jointly determine a maximum SOC corresponding to maximum cell voltage in the real-time parameters and a minimum SOC corresponding to minimum cell voltage in the real-time parameters based on a preset noise adaptive extended Kalman filter (AEKF) algorithm and the Thevenin model and according to the real-time parameters of the to-be-tested battery pack and the output result; and
a second determination unit, configured to determine an overall SOC of the to-be-tested battery pack according to the maximum SOC and the minimum SOC.

10. An electronic device, comprising a processor and a memory that are coupled to each other, wherein the memory has a computer program stored therein, and the computer program, when executed by the processor, causes the electronic device to execute the method according to any one of claims 1 to 7.

11. A battery module, comprising a module body formed by connecting a plurality of battery cells in series and/or in parallel and the electronic device according to claim 10, wherein the module body is provided with a sensor that is electrically connected with the electronic device, and the sensor is configured to detect electric parameters of each battery cell of the plurality of battery cells.

12. A computer-readable storage medium having a computer program stored therein, wherein the computer program, when run on a computer, causes the computer to execute the method according to any one of claims 1 to 7.

Fit a relationship between an open-circuit voltage (OCV) and a state of charge (SOC) based on the OCV corresponding to an SOC range of 0 to 100% for a tested battery pack to obtain an OCV-SOC function /— 110

Create a Thevenin model of the tested battery pack based on equivalent circuit parameters of a battery cell in the tested battery pack and the OCV-SOC function /— 120

Input real-time parameters acquired from a to-be-tested battery pack into the Thevenin model for detection according to a preset VFF-RLS algorithm with a time-varying forgetting factor to obtain an output result, the output result including a terminal voltage and a terminal voltage residual /— 130

ointly determine a maximum SOC corresponding to a maximum cell voltage in the real-time parameters and a minimum SOC corresponding to a minimum cell voltage in the real-time parameters based on a preset noise adaptive extended Kalman filter (AEKF) algorithm and the Thevenin model and according to the real-time parameters of the to-be-tested battery pack and the output result /— 140

Determine an overall SOC of the to-be-tested battery pack according to the maximum SOC and the minimum SOC /— 150

Fig. 1

Fig. 2

Fig. 3

Fig. 4

Fig. 5

Fig. 6

Fig. 7

## INTERNATIONAL SEARCH REPORT

| International application No. |
| --- |
| **PCT/CN2023/119842** |

### A. CLASSIFICATION OF SUBJECT MATTER

G01R31/367(2019.01)i

According to International Patent Classification (IPC) or to both national classification and IPC

### B. FIELDS SEARCHED

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNABS; CNTXT; DWPI; WPABS; USTXT; EPTXT; WOTXT; CNKI: 长安汽车, 郑昌文, 郑英, 朱骞, 杨旭, 喻成, 电池, 荷电状态, 剩余电量, 残余电量, 剩余容量, 残余容量, 一阶RC, 戴维南, 变遗忘因子, 最小二乘, 自适应扩展卡尔曼, 最大, 最高, 最小, 最低, battery, cell, SOC, state of charg+, thevenin, VFF, RLS, AEKF, max, min

### C. DOCUMENTS CONSIDERED TO BE RELEVANT

| Category* | Citation of document, with indication, where appropriate, of the relevant passages | Relevant to claim No. |
| --- | --- | --- |
| PX | CN 116224073 A (CHONGQING CHANG'AN AUTOMOBILE CO., LTD.) 06 June 2023 (2023-06-06) <br> claims 1-12 | 1-12 |
| Y | 米玉轩 (MI, Yuxuan). "车用锂离子动力电池模型参数的在线辨识算法研究 (Non-official translation: Research on Online Identification Algorithm of Vehicle Lithium-Ion Power Battery Model Parameters)" <br> *中国优秀硕士学位论文全文数据库 工程科技II辑 (Chinese Master's Theses Full-Text Database, Engineering Science & Technology II)*, No. 7, 15 July 2021 (2021-07-15), pages C035-428 <br> ISSN: 1674-0246, <br> abstract, sections 1.2.2, 3.1, and 4.1-4.5 | 1-12 |
| Y | CN 112083333 A (KUNMING UNIVERSITY OF SCIENCE AND TECHNOLOGY) 15 December 2020 (2020-12-15) <br> claims 1-5 | 1-12 |

☑ Further documents are listed in the continuation of Box C. ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **21 November 2023** | **05 December 2023** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**EP 4 603 850 A1**

## INTERNATIONAL SEARCH REPORT

| International application No. |
| --- |
| **PCT/CN2023/119842** |

### C.    DOCUMENTS CONSIDERED TO BE RELEVANT

| Category* | Citation of document, with indication, where appropriate, of the relevant passages | Relevant to claim No. |
| --- | --- | --- |
| Y | 董策勇 (DONG, Ceyong). "基于改进RLS算法的锂电池模型参数识别与SOC估计 (Parameter Identification and SOC Estimation of Lithium Battery Model Based on Improved RLS Algorithm)" 兰州文理学院学报(自然科学版) (*Journal of LanZhou University of Arts And Science (Natural Sciences Edition))*, Vol. 36, No. 4, 10 July 2022 (2022-07-10), pages 31-35 ISSN: 2095-6991, abstract, and sections 0-5 | 1, 2, 7-12 |
| A | CN 113030752 A (ANHUI UNIVERSITY OF SCIENCE & TECHNOLOGY) 25 June 2021 (2021-06-25) entire document | 1-12 |
| A | CN 115015767 A (SOUTH CHINA UNIVERSITY OF TECHNOLOGY) 06 September 2022 (2022-09-06) entire document | 1-12 |
| A | WO 2021197038 A1 (BYD CO., LTD.) 07 October 2021 (2021-10-07) entire document | 1-12 |

Form PCT/ISA/210 (second sheet) (July 2022)

24

**INTERNATIONAL SEARCH REPORT**
Information on patent family members

International application No.

**PCT/CN2023/119842**

| Patent document cited in search report | | | Publication date (day/month/year) | Patent family member(s) | Publication date (day/month/year) |
|---|---|---|---|---|---|
| CN | 116224073 | A | 06 June 2023 | None | |
| CN | 112083333 | A | 15 December 2020 | None | |
| CN | 113030752 | A | 25 June 2021 | None | |
| CN | 115015767 | A | 06 September 2022 | None | |
| WO | 2021197038 | A1 | 07 October 2021 | None | |

Form PCT/ISA/210 (patent family annex) (July 2022)